# EUROPEAN PATENT SPECIFICATION

(11) **EP 4 213 607 B1**
(45) Date of publication and mention of the grant of the patent: **27.05.2026**
(21) Application number: 22151284.1
(22) Date of filing: 13.01.2022
(51) Int. Cl.: H10D 12/00, H10D 64/27, H10D 84/00, H10D 62/13, H10N 97/00, H10D 1/47

(54) **SEMICONDUCTOR DEVICE AND METHOD FOR OPERATING A SEMICONDUCTOR DEVICE**
HALBLEITERBAUELEMENT UND VERFAHREN ZUM BETRIEB EINES HALBLEITERBAUELEMENTS
DISPOSITIF À SEMI-CONDUCTEURS ET PROCÉDÉ DE FONCTIONNEMENT D'UN DISPOSITIF À SEMI-CONDUCTEURS

(43) Date of publication of application: 19.07.2023
(73) Proprietor: Hitachi Energy Ltd, 8050 Zürich (CH)
(72) Inventor: BOKSTEEN, Boni Kofi, 5600 Lenzburg (CH); VITALE, Wolfgang Amadeus, 6340 Baar (CH); TAMIL SELVA, Kruphalan, 72335 Västerås (SE); MESEMANOLIS, Athanasios, 8404 Winterthur (CH)
(74) Representative: Epping - Hermann - Fischer

(56) References cited:
- EP-A1- 2 937 960
- EP-A1- 3 598 505
- US-A1- 2010 001 785
- US-A1- 2016 163 689

## Description

The present disclosure relates to a semiconductor device and to a method for operating a semiconductor device.

Short circuit ruggedness is an important requirement for most applications, e.g., in power electronics. During short circuit, the device has to withstand both a high voltage and a high current for a certain period of time. If the short circuit condition is not detected or limited early enough, the device will eventually be destroyed. The understanding of short circuit is a topic of great research interest, as the failure can occur in different parts of the short circuit pulse (turn-on, plateau, turn-off, thermal runaway) and the underlying physical mechanism can be of a different nature. Even a single weak chip failing in short circuit conditions might cause explosions, dealing critical damage to the whole system. The importance of preventing short circuit failures leads to design constraints which might cause a hard limitation of the device performance.

Document US 2016/163689 A1 concerns a semiconductor devices with transistor cells and a thermoresistive element. Document EP 2 937 960 A1 concerns a method of automatically cutting off high temperature and high current. Document US 2010/001785 A1 concerns a semiconductor component and a method of determining temperature.

There is a need for an improved semiconductor device, e.g. for a semiconductor device with an automatic short circuit suppression and/or an improved short circuit ruggedness. Furthermore, there is a need for a method for operating such a semiconductor device.

Embodiments of the disclosure relate to an improved semiconductor device, e.g. to a semiconductor device with an automatic short circuit detection and suppression and/or an improved short circuit ruggedness. Further embodiments relate to a method for operating such a semiconductor device.

The invention is defined in the claims. In the following, portions of the description and drawings relating to embodiments not covered by the claims are not presented as embodiments of the invention, but as examples useful in understanding the invention.

First, the semiconductor device is specified.

According to an embodiment, as defined in claim 1, the semiconductor device comprises a semiconductor body, a first electrode, a gate electrode and a variable resistor element. The variable resistor element is electrically connected to the gate electrode and to the first electrode. The variable resistor element has at least a first and a second state. In the first state, the variable resistor element acts as an electrical insulator in order to suppress electrical current from flowing from the first electrode to the gate electrode or vice versa via the variable resistor element. In the second state, the variable resistor element acts as an electrical conductor in order to allow electrical current to flow from the first electrode to the gate electrode or vice versa via the variable resistor element. The variable resistor element is configured to make a transition from the first state into the second state when a temperature of the variable resistor element rises above a critical temperature Tc.

With the variable resistor element between the first electrode and the gate electrode, a smart gate signal fuse for short circuit detection and reaction is realized. The variable resistor element has a very low electrical conductivity in the normal operating conditions of the device, i.e. when the temperature is below Tc. Hence, the variable resistor element effectively acts as an electrical insulator. If the device, and with it the variable resistor element, heats up above the critical temperature Tc, e.g. due to a short circuit, it undergoes a thermally induced increase in electrical conductivity such that it effectively acts as a conductor.

For example, in the case of the semiconductor device being an insulated gate transistor, when a gate voltage V_{1E} (voltage between first electrode and gate electrode) is applied higher than a threshold voltage V_{TH}, a high current starts flowing through the device, leading to an increase in the average temperature of the device. During normal operating conditions, this increase in temperature is not enough to reach the critical temperature Tc at the locations in which the variable resistor element is arranged. However, in short circuit condition, e.g. when the device is in the blocking state, the device reaches higher temperature levels, eventually above the critical temperature Tc. Once the variable resistor element starts conducting, the gate voltage V_{1E} drops, eventually below Vₜₕ, reducing the current through the device. The reduction in current allows to stop self-heating and the destruction of the device even in the case of late external detection.

Thus, one benefit of the presented semiconductor device is that it allows for fast on-chip short-circuit detection and reaction. This provides all accompanying chip optimization benefits of fast short-circuit detection systems without being limited to the more complex "fast" detection system on system level, i.e. off-chip. The on-chip protection method disclosed herein would therefore provide, inter alia, the opportunity to reduce the cost/complexity of system level short-circuit protection designs.

The semiconductor device may be a semiconductor chip. The semiconductor body is, e.g., based on silicon. The first electrode may be an emitter electrode, e.g. in the case that the semiconductor device is an IGBT or RC-IGBT. Alternatively, the first electrode may be a source electrode, e.g. in the case that the semiconductor device is a MOSFET. The first electrode may comprise or consist of metal.

The gate electrode may be electrically insulated from the semiconductor body and/or from the first electrode in normal operation of the semiconductor device. In other words, the semiconductor device may be an insulated gate device. For example, an insulating material, like SiO₂, is arranged between the gate electrode and the semiconductor body. Thus, when the variable resistor element is in the first state, the gate electrode is electrically isolated from the semiconductor body and/or from the first electrode. The gate electrode may comprise or consist of one or more of: metal, highly doped polysilicon.

The variable resistor element may extend through the insulating material. For example, the insulating material laterally surrounds the resistor element. A lateral direction is herein understood to be a direction parallel to a main extension plane of the semiconductor body.

The variable resistor element is electrically connected to the gate electrode and to the first electrode. This means that the variable resistor element is directly or indirectly electrically connected to the gate electrode and/or to the first electrode. "Directly electrically connected" herein means that the variable resistor element directly contacts the respective electrode, i.e. there is a direct mechanical contact. "Indirectly electrically connected" herein means that there is no direct mechanical contact but a further electrically conductive material, like a part of the semiconductor body, is arranged between the variable resistor element and the respective electrode. For example, the variable resistor element is directly electrically connected to the gate electrode and indirectly electrically connected to the first electrode. For instance, the variable resistor element is arranged between the gate electrode and the semiconductor body.

In the first state, the variable resistor element effectively acts as an insulator. For example, in the first state, the variable resistor element has an electrical conductivity of at most 10 S/m or at most 1·10⁻² S/m or at most 1·10⁻⁵ S/m.

In the second state, the variable resistor element effectively acts as a conductor. For example, in the second state, the variable resistor element has an electrical conductivity of at least 10² S/m or at least 10⁵ S/m or at least 10⁸ S/m.

For example, the variable resistor element is configured such that, when a voltage difference v_{1E} between the gate electrode and the first electrode appears in the first state of the variable resistor element and the variable resistor element then switches into the second state, the voltage difference v_{1E} automatically reduces due to an electrical current flowing between the electrodes via the variable resistor element. For example, v_{1E} then reduces by at least 20 % or at least 50 % or at least 90 %. For example, a voltage difference v_{1E} above the threshold voltage vₜₕ of the semiconductor device in the first state reduces to a voltage difference below vₜₕ in the second state.

The variable resistor element may be configured to make the transition from the first into the second state automatically. This means that the variable resistor element is not externally switched from the first state into the second state. Rather, the physical and/or chemical properties of the variable resistor element influencing the resistance of the variable resistor element are temperature dependent so that a change in the temperature above Tc automatically leads to a change in the resistance of the variable resistor element. Alternatively, the variable resistor element may be configured to make the transition from the first into the second state by triggering, e.g. external triggering.

The variable resistor element is configured to make a transition from the first state into the second state when the temperature rises above the critical temperature Tc. This may mean that, when the temperature increases from T < Tc to the temperature Tc, the variable resistor element remains in the first state. When further increasing the temperature from Tc by ΔT, the electrical conductivity changes such that at the temperature Tc+ΔT, the variable resistor element is in the second state. In other words, the transition occurs in the range Tc < T < T+ΔT.

According to the invention, the variable resistor element is located in a region of the semiconductor device below a gate pad terminal of the gate electrode. The gate pad terminal is the region of the gate electrode which is configured to be externally electrically contacted when operating the semiconductor device. For example, the gate pad terminal is arranged at an edge and/or in a corner of the semiconductor device. The gate pad terminal may be a region of the gate electrode in which the gate electrode has the largest diameter/width. In top view, the gate pad terminal may have a rectangular shape.

According to the invention, the semiconductor device comprises several variable resistor elements. All features disclosed in connection with one resistor element so far and in the following are also disclosed for the other resistor elements. The different resistor elements are arranged at different locations of the semiconductor device.

According to the invention, the different variable resistor elements are spaced from each other. The variable resistor elements are connected in parallel to each other between the gate electrode and the first electrode.

According to the invention, a plurality of variable resistor element is arranged below a gate runner of the gate electrode. The gate runner is a portion of the gate electrode which extends around the first electrode in lateral direction and/or which extends along the edges of the semiconductor device. For example, the gate runner extends from the gate pad terminal along the edge of the semiconductor device until it again reaches the gate pad terminal. The gate runner may be frame-shaped.

For example, the variable resistor elements are arranged uniformly along the extension of the gate runner, i.e. with constant distances.

The variable resistor element may be arranged between the gate electrode and the semiconductor body and/or may at least partially extend into the semiconductor body. For example, the variable resistor element is at least partially laterally surrounded by the semiconductor body.

That a variable resistor element is arranged below an electrode may mean that, in top view, e.g. on a main side of the semiconductor body, the electrode overlaps with the variable resistor element.

In top view, the variable resistor element may have an oval or round or rectangular shape. For example, a maximum lateral expansion of the variable resistor element is at least 1 µm or at least 10 µm and/or at most 1000 µm or at most 100 µm. According to a further embodiment, the variable resistor element is located in a region of the semiconductor device which is expected to have the highest temperature during a short circuit. The region where the highest temperature is expected may be determined with help of computer simulations.

The location of the variable resistor element may be chosen depending on the short circuit protection requirements. For example, for a fast response of the resistor element, the resistor element is located near the heat source or the region where the short circuit appears. For a slower response of the resistor element, the resistor element is located further away of the heat source or the region where the short circuit appears.

According to a further embodiment, the variable resistor element comprises or consists of at least one phase change material, PCM for short. The phase change material is a material which changes its phase, e.g. from amorphous to crystalline, when the temperature is raised above the critical temperature Tc, thus, potentially providing a large change in the electrical conductivity.

According to a further embodiment, an electrical conductivity of the variable resistor element in the second state is at least 10 times or at least 100 times or at least 10³ times or at least 10⁴ times or at least 10⁵ times or at least 10⁶ times the electrical conductivity of the variable resistor element in the first state.

According to a further embodiment, the variable resistor element is configured to make an abrupt transition from the first state into the second state when the temperature of the variable resistor element rises above the critical temperature Tc. The expression "abrupt" herein concerns the temperature range ΔT within which the transition happens. For example, the temperature range ΔT, within which the transition from the first state into the second state occurs, is at most 30°C or at most 10°C or at most 5°C. This type of variable resistor element may herein also be referred to as digital variable resistor element.

Alternatively, the variable resistor element may be configured to make a smooth or gradual transition from the first state into the second state when the temperature of the variable resistor element rises above the critical temperature Tc. Again, "smooth" or "gradual" concerns the temperature range ΔT. For example, the temperature range ΔT within which the transition from the first state into the second state occurs is at least 50°C or at least 75°C or at least 100°C and/or at most 200°C. This type of variable resistor element may herein also be referred to as analog variable resistor element. With such a variable resistor element, a self-regulating gate current can be achieved.

For example, by a adjusting a doping concentration in the material of the resistor element, the critical temperature Tc and/or the temperature range ΔT can be adjusted

According to a further embodiment, the critical temperature Tc is at least 50°C or at least 75°C or at least 100°C larger than a normal operation temperature of the semiconductor device. The normal operation temperature of the semiconductor device, i.e. the operation mode where no short-circuit appears, may be at least 100°C and/or at most 200°C.

According to a further embodiment, the variable resistor element comprises or consists of one or more of the following materials: GeTe, Al-doped Ge₂Sb₂Te₅, namely Alₓ(Ge₂Sb₂Te₅)₁₋ₓ, with, e.g., 0 ≤ x ≤ 0.3. The larger the value of x, the higher the critical temperature Tc but the smoother the transition from the first state into the second state. The mentioned materials are example of phase change materials.

According to a further embodiment, a transition of the variable resistor element from the first state into the second state is reversible. This means that, after switching from the first state into the second state by increasing the temperature and when then reducing the temperature starting from the second state below the critical temperature Tc, the variable resistor element switches, e.g. automatically, into the first state. This case may be advantageous, since it allows to operate the semiconductor device as usual after a short circuit. For example, the resistor element may comprise or consist of one or more vanadium oxide based materials in order to achieve the reversibility.

According to a further embodiment, the transition of the variable resistor element from the first state into the second state is irreversible. This means that, after switching from the first state into the second state by increasing the temperature and when then reducing the temperature starting from the second state below the critical temperature, the variable resistor element does not automatically switch back into the first state. For example it remains in the second state or it switches into a third state which is different from the first state. The third state may be a state where the variable resistor element still behaves like a conductor. For example, the resistor element may comprise or consist of one or more titanium oxide based materials in order to achieve the irreversibility. According to a further embodiment, the semiconductor device is a power semiconductor device. For example, an operation voltage of the semiconductor device is at least 500 V or at least 1000 V or at least 3000 V or at least 6000 V. The operation voltage may be the voltage between the first electrode and a second electrode during normal operation of the semiconductor device.

According to a further embodiment, the semiconductor device is or comprises an Insulated Gate Bipolar Transistor, IGBT for short. The semiconductor device may comprise or may be a Reverse-Conducting Insulated Gate Bipolar Transistor, RC-IGBT for short, e.g. a Bi-mode Insulated Gate Transistor, BIGT for short.

According to a further embodiment, the semiconductor device is or comprises a MOSFET.

According to a further embodiment, the semiconductor device is or comprises a thyristor, e.g. an IGCT or a GTO.

Next, the method for operating a semiconductor device is specified. A semiconductor device according to any one of the embodiments as defined in claims 1 to 8 is operated with the method. Therefore, all features disclosed in connection with the semiconductor device are also disclosed for the method and vice versa.

According to an embodiment, the method for operating a semiconductor, as defined in claim 9, comprises
- operating the semiconductor device with the variable resistor element being in the first state until a short circuit appears in the semiconductor device due to which the temperature in the variable resistor element increase above the critical temperature Tc,
- switching the variable resistor element from the first state into the second state,
- guiding an electrical current between the semiconductor body and the gate electrode through the variable resistor element being in the second state.

Operating the semiconductor device with the variable resistor element in the first state may comprise applying a voltage difference between the first electrode and the gate electrode and/or injecting an electrical current through the first electrode. The short circuit may appear in a blocking state of the semiconductor device. The switching from the first state to the second state may happen automatically or may be triggered when the temperature rises above the critical temperature. Guiding an electrical current through the variable resistor element may happen automatically when the variable resistor element is in the second state. For example, due to a voltage difference between first electrode and the gate electrode, a current automatically flows through the variable resistor element when being in the second state. Hereinafter, the semiconductor device will be explained in more detail with reference to drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures.

For the sake of clarity, elements might not appear with corresponding reference symbols in all figures.

Figure 1 shows a first exemplary embodiment of a semiconductor device in a cross-sectional view, this embodiment is not claimed but it is useful for understanding the invention,

Figures 2 and 3 show a second exemplary embodiment of a semiconductor device in different views, this embodiment is not claimed but it is useful for understanding the invention,

Figure 4 shows an embodment of the invention;

Figure 5 shows measurements for a phase change material,

Figure 6 shows a flow chart of an exemplary embodiment of the method for operating a semiconductor device.

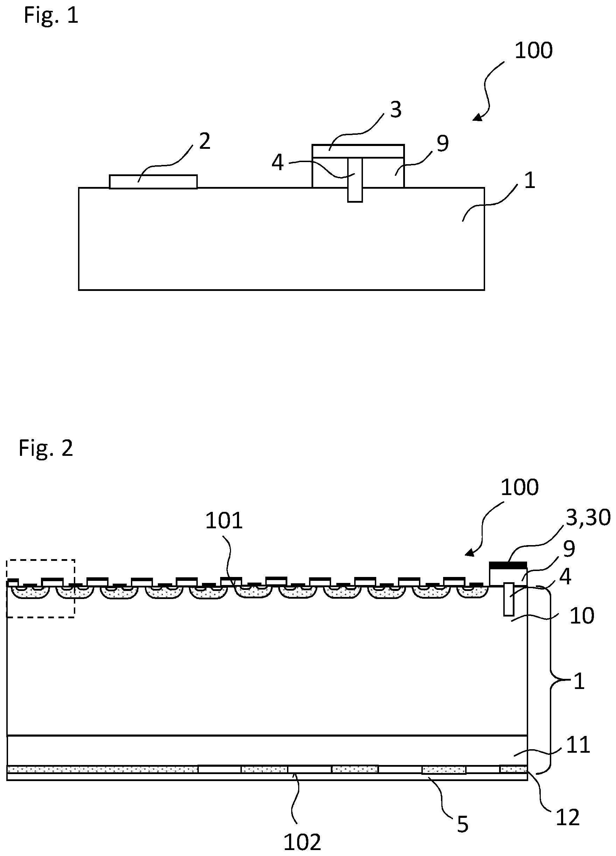

The first exemplary unclaimed embodiment of the semiconductor device 100 of figure 1 comprises a semiconductor body 1, e.g. on the basis of silicon. On a top side of the semiconductor body 1, a first electrode 2 and a gate electrode 3 are arranged. The gate electrode 3 is spaced from the semiconductor body 1 by an insulating material 9, e.g. comprising or consisting of SiO₂. A variable resistor element 4 extends from that gate electrode 3 through the insulating material 9 into the semiconductor body 1. In lateral direction, parallel to a main extension plane of the semiconductor body 1, the variable resistor element 4 is surrounded, e.g. completely surrounded, by the insulating material 9.

The variable resistor element 4 is in direct electrical contact 4 with the gate electrode 3 and is in indirect electrical contact with the first electrode 2 via the semiconductor material of the semiconductor body 1.

The variable resistor element 4 comprises at least two states. In a first state, the variable resistor element 4 acts as or behaves like an electrical insulator in order to suppress or prevent electrical current from flowing between the first electrode 2 and the gate electrodes 3. When the variable resistor element 4 heats up above a critical temperature Tc, the variable resistor element 4 makes a transition from the first state into a second state, in which the variable resistor element 4 acts as or behaves like an electrical conductor in order to allow electrical current to flow between the first electrode 2 and the gate electrode 3 via the variable resistor element 4. For example, the transition happens automatically.

Normally, a short circuit within a semiconductor device results in a rapid temperature increase. Such a short circuit may appear when a voltage between the first electrode 2 and the gate electrode 3 unintentionally rises above a threshold voltage vₜₕ. The variable resistor element 4 is configured to recognize such as a short circuit on the basis of the rapid temperature increase and to react on this short circuit by providing a current path between the first electrode 2 and the gate electrode 3. With electrical current flowing from the first electrode 2 to the gate electrode 3 or vice versa, the voltage difference between the first electrode 2 and the gate electrode 3 is taken down so that the short circuit can be stopped. In other words, the variable resistor element 4 automatically detects a short circuit and automatically turns-off the short circuit. The current path provided by the variable resistor element 4 in the second state may put the gate electrode to ground.

The dielectric constant of the material of the variable resistor element 4 is, e.g., chosen such that possible effects on the capacitance between the gate electrode 3 and first electrode 2 are considered. For example, the dielectric constant of the material of the variable resistor element 4 is chosen to be equal to or smaller than the dielectric constant of the insulating material 9. The variable resistor element 4 may comprise or consist of one or more of: GeTe, Al-doped Ge₂Sb₂Te₅.

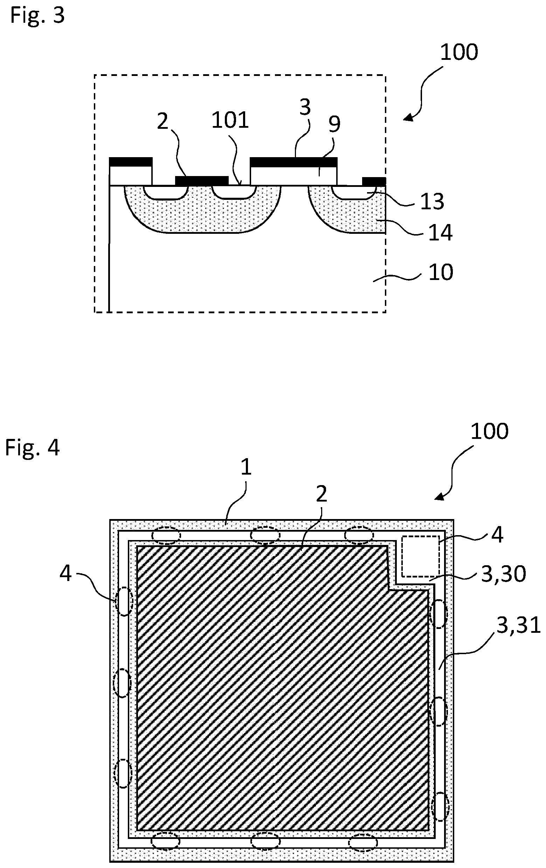

In the second exemplary embodiment of the semiconductor device 100 of the figures 2 to 4, the semiconductor device 100 is realized as a Reverse-Conducting Insulated Gate Bipolar Transistor, RC-IGBT for short. Thereby, figure 2 is a cross-sectional view. Figure 4 shows the RC-IGBT 100 in top view of the emitter side 101 of the RC-IGBT 1000. Figure 3 shows the framed section of figure 2 in greater detail.

The RC-IGBT 100 comprises a semiconductor body 1 with a base layer 10, a buffer layer 11, and a collector layer 12. The buffer layer 10 and the base layer 11 are, e.g., n-doped. For example, the doping concentration in the buffer layer 11 is greater than in the base layer 10. The base layer 10 may be thicker than the buffer layer 11. Moreover, the base layer 10 and/or the buffer layer 11 may be thicker than the collector layer 12 of the semiconductor body 1. The collector layer 12 comprises regions of different doping types, i.e. p-doped and n-doped regions. The collector layer 12 forms a collector side 102 of the RC-IGBT 100. A collector electrode 5 is arranged on top of the collector side 102 and is in electrical contact with the collector side 102. The collector electrode 5 is, e.g., of metal.

At an emitter side 101, opposite the collector side 102, the semiconductor body 1 comprises a plurality of well regions 14 (for better illustration, see figure 3). The well regions 14 are, e.g. p-doped. Embedded into the well regions 14 are emitter regions 13, which are, e.g., n-doped. On top of the emitter side 101, a first electrode 2 or emitter electrode 2, respectively, is arranged which is in electrical contact to the emitter regions 13. Furthermore, a gate electrode 3 is arranged on the emitter side 101 and is insulated from the semiconductor body 1 by insulating material 9. The emitter electrode 2 and the gate electrode 3 are, e.g., formed of metal.

In an edge region of the RC-IGBT 100, the gate electrode 2 is electrically connected to a variable resistor element 4. The variable resistor element 4 is furthermore connected to the semiconductor body 1. The resistor element 4 can be the variable resistor element 4 of the first exemplary unclaimed embodiment, e.g. in terms of the material. As soon as the variable resistor element 4 switches from the first state into the second state, electric current can flow between the emitter electrode 2 and the gate electrode 3 via the variable resistor element 4.

Looking now at figure 4, the RC-IGBT 100 is shown in a top view of the emission side 101. As can be seen, the gate electrode 3 comprises a gate pad terminal 30 in the corner of the device 100 and a gate runner 31. The gate runner 31 extends along the edges of the RC-IGBT 100 and laterally surrounds the emitter electrode 2 in a frame-like manner.

In the region of the gate pad terminal 30, a first variable resistor element 4 is arranged. This variable resistor element 4 is indicated by dashed lines, since it is actually hidden below the gate pad terminal 30. Along the gate runner 31, further variable resistor elements 4 are arranged and are also indicated by dashed ellipses since they are actually hidden. The further variable resistor elements 4 are, e.g., uniformly distributed along the gate runner 31.

Placing one variable resistor element 4 below the gate pad terminal 30 is advantageous since this is the region where normally an external electrical contact is realized so that an unintentional high voltage drop between the gate electrode 3 and the emitter electrode 2 potentially resulting in a short-circuit first appears in the region of the gate pad terminal 30. Thus, the variable resistor element 4 in this region can react particularly fast on a short circuit.

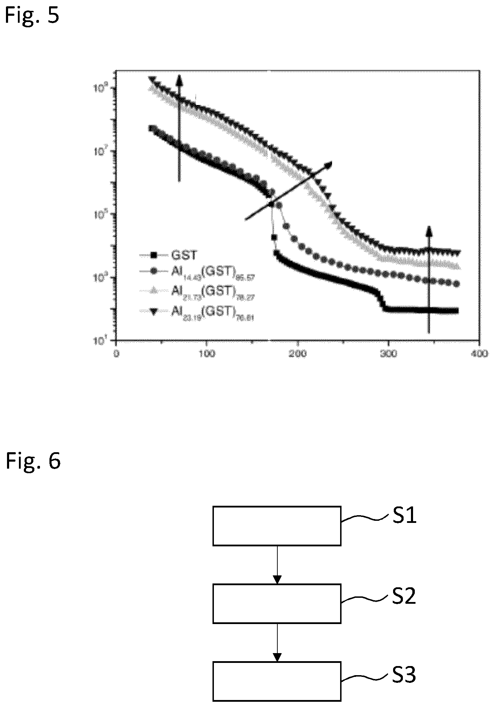

Figure 5 shows measurement results for the sheet resistance of Alₓ(Ge₂Sb₂Te₅)₁₋ₓ taken from Wang et al., Improved thermal and electrical properties of Al-doped Ge2Sb2Te5 films for phase-change random access memory, Journal of Physics D Applied Physics, 2012, DOI:10.1088/0022-3727/45/37/375302, the disclosure content of which is hereby incorporated by reference. On the x-axis, the temperature in °C is indicated. On the y-axis, the sheet resistance in Ω/□ is indicated. Altogether, four measurement curves are shown, namely for different vales of x (x=0, x=0.1443, x=0.2173, x=0.2319). Before the drop in the sheet resistance, the material is amorphous, afterwards, the material is crystalline. Alₓ(Ge₂Sb₂Te₅)₁₋ₓ is a phase change material. As can be seen in figure 5, at x=0, the material has an abrupt transition from insulator to conductor at Tc ≈ 170°C. For higher contributions of Al, the transition gets smoother and also the critical temperature Tc increases.

Figure 6 shows a flow chart of an exemplary embodiment of the method for operating the semiconductor device. In a step S1 of the method, a semiconductor device, e.g. one of the figures 1 to 4, is operated with the variable resistor element being in the first state. This is done such that or until a short circuit appears in the semiconductor device. Due to the short circuit, the temperature in the variable resistor element rises above the critical temperature Tc.

In a further step S2, the variable resistor element switches from the first state into the second state. This may happen automatically due to the rise above the critical temperature Tc.

Then, in a step S3, an electrical current flows between the semiconductor body and the gate electrode through the variable resistor element being in the second state. This may also happen automatically, e.g. as long as a voltage difference is present between the first electrode and the gate electrode.

### Reference Signs

- 1: semiconductor body
- 2: first electrode
- 3: gate electrode
- 4: variable resistor element
- 5: second electrode/ collector electrode
- 9: electrically insulating material
- 10: base layer
- 11: buffer layer
- 12: collector layer
- 30: gate pad terminal
- 31: gate runner
- 100: semiconductor device
- 101: emitter side
- 102: collector side
- S1 - S2: method steps

## Claims

1. Semiconductor device (100) comprising
- a semiconductor body (1),
- a first electrode (2),
- a gate electrode (3),
- a plurality of variable resistor elements (4) arranged at different locations of the semiconductor device (100) and being spaced from each other, wherein
- the variable resistor elements (4) are electrically connected to the gate electrode (3) and to the first electrode (2),
- the variable resistor elements (4) each have at least a first and a second state,
- in the first state, the variable resistor elements (4) act as an electrical insulator in order to suppress electrical current from flowing from the first electrode (2) to the gate electrode (3) or vice versa via the variable resistor elements (4),
- in the second state, the variable resistor elements (4) act as an electrical conductor in order to allow electrical current to flow from the first electrode (2) to the gate electrode (3) or vice versa via the variable resistor elements (4),
- the variable resistor elements (4) are configured to make a transition from the first state into the second state when a temperature of the variable resistor element (4) rises above a critical temperature Tc, **characterized in that**
- a variable resistor element (4) is located in a region of the semiconductor device (100) below a gate pad terminal (30) of the gate electrode (3) and a plurality of variable resistor elements (4) is located below a gate runner (31) of the gate electrode (3).

2. Semiconductor device (100) according to claim 1, wherein
- the variable resistor elements (4) comprise a phase change material.

3. Semiconductor device (100) according to any of the preceding claims, wherein
- an electrical conductivity of the variable resistor elements (4) in the second state is at least 100-times the electrical conductivity of the variable resistor element (4) in the first state.

4. Semiconductor element (100) according to any of the preceding claims, wherein
- the variable resistor elements (4) are configured to make an abrupt transition from the first into the second state when the temperature of the variable resistor element (4) rises above the critical temperature Tc.

5. Semiconductor device (100) according to any of the preceding claims, wherein
- the critical temperature Tc is at least 50°C larger than a normal operation temperature of the semiconductor device (100).

6. Semiconductor device (100) according to any of the preceding claims, wherein
- the variable resistor elements (4) comprise or consist of one or more of the following materials: GeTe, Al-doped Ge₂Sb₂Te₅.

7. Semiconductor device (100) according to any of the preceding claims, wherein
- the semiconductor device is a power semiconductor device.

8. Semiconductor device (100) according to any of the preceding claims, wherein
- the semiconductor device (100) comprises an Insulated Gate Bipolar Transistor and/or a MOSFET.

9. A method for operating a semiconductor device (100) according to any one of the preceding claims, comprising
- operating the semiconductor device (100) with the variable resistor elements (4) being in the first state until a short circuit appears in the semiconductor device (100) due to which the temperature in the variable resistor elements (4) rises above the critical temperature Tc,
- switching the variable resistor elements (4) from the first state into the second state,
- guiding an electrical current between the semiconductor body (1) and the gate electrode (3) through the variable resistor elements (4) being in the second state.

## Patentansprüche

1. Halbleitervorrichtung (100), umfassend
- einen Halbleiterkörper (1),
- eine erste Elektrode (2),
- eine Gate-Elektrode (3),
- eine Vielzahl von variablen Widerstandselementen (4), die an verschiedenen Stellen der Halbleitervorrichtung (100) angeordnet sind und voneinander beabstandet sind, wobei
- die variablen Widerstandselemente (4) elektrisch mit der Gate-Elektrode (3) und der ersten Elektrode (2) verbunden sind;
- die variablen Widerstandselemente (4) jeweils mindestens einen ersten und einen zweiten Zustand aufweisen;
- im ersten Zustand die variablen Widerstandselemente (4) als elektrischer Isolator fungieren, um den elektrischen Stromfluss von der ersten Elektrode (2) zur Gate-Elektrode (3) oder umgekehrt über die variablen Widerstandselemente (4) zu unterdrücken;
- im zweiten Zustand die variablen Widerstandselemente (4) als elektrischer Leiter fungieren, um den elektrischen Stromfluss von der ersten Elektrode (2) zur Gate-Elektrode (3) oder umgekehrt über die variablen Widerstandselemente (4) zu erlauben;
- die variablen Widerstandselemente (4) dazu konfiguriert sind, einen Übergang vom ersten Zustand in den zweiten Zustand vorzunehmen, wenn eine Temperatur des variablen Widerstandselements (4) über eine kritische Temperatur Tc steigt, **dadurch gekennzeichnet, dass**
- sich ein variables Widerstandselement (4) in einem Bereich der Halbleitervorrichtung (100) unter einem Gate-Pad-Anschluss (30) der Gate-Elektrode (3) befindet und sich eine Vielzahl von variablen Widerstandselementen (4) unter einem Gate-Läufer (31) der Gate-Elektrode (3) befindet.

2. Halbleitervorrichtung (100) nach Anspruch 1, wobei
- die variablen Widerstandselemente (4) ein Phasenwechselmaterial umfassen.

3. Halbleitervorrichtung (100) nach einem der vorhergehenden Ansprüche, wobei
- eine elektrische Leitfähigkeit der variablen Widerstandselemente (4) im zweiten Zustand mindestens das 100-fache der elektrischen Leitfähigkeit des variablen Widerstandselements (4) im ersten Zustand ist.

4. Halbleitervorrichtung (100) nach einem der vorhergehenden Ansprüche, wobei
- die variablen Widerstandselemente (4) dazu konfiguriert sind, einen abrupten Übergang vom ersten in den zweiten Zustand vorzunehmen, wenn die Temperatur des variablen Widerstandselements (4) über die kritische Temperatur Tc steigt.

5. Halbleitervorrichtung (100) nach einem der vorhergehenden Ansprüche, wobei
- die kritische Temperatur Tc mindestens 50°C höher als eine normale Betriebstemperatur der Halbleitervorrichtung (100) ist.

6. Halbleitervorrichtung (100) nach einem der vorhergehenden Ansprüche, wobei
- die variablen Widerstandselemente (4) ein oder mehrere der folgenden Materialien umfassen oder daraus bestehen: GeTe, Al-dotiertes Ge₂Sb₂Te₅.

7. Halbleitervorrichtung (100) nach einem der vorhergehenden Ansprüche, wobei
- die Halbleitervorrichtung eine Leistungshalbleitervorrichtung ist.

8. Halbleitervorrichtung (100) nach einem der vorhergehenden Ansprüche, wobei
- die Halbleitervorrichtung (100) einen Bipolartransistor mit isoliertem Gate und/oder einen MOSFET umfasst.

9. Verfahren zum Betreiben einer Halbleitervorrichtung (100) nach einem der vorhergehenden Ansprüche, umfassend
- Betreiben der Halbleitervorrichtung (100) mit den im ersten Zustand befindlichen variablen Widerstandselemente (4), bis ein Kurzschluss in der Halbleitervorrichtung (100) auftritt, aufgrund dessen die Temperatur in den variablen Widerstandselementen (4) über die kritische Temperatur Tc steigt,
- Umschalten der variablen Widerstandselemente (4) vom ersten Zustand in den zweiten Zustand,
- Leiten eines elektrischen Stroms zwischen dem Halbleiterkörper (1) und der Gate-Elektrode (3) durch die im zweiten Zustand befindlichen variablen Widerstandselemente (4).

## Revendications

1. Dispositif semi-conducteur (100) comprenant
- un corps semi-conducteur (1),
- une première électrode (2),
- une électrode de grille (3),
- une pluralité d'éléments résistifs variables (4) disposés à différents emplacements du dispositif semi-conducteur (100) et étant espacés les uns des autres, dans lequel
- les éléments résistifs variables (4) sont reliés électriquement à l'électrode de grille (3) et à la première électrode (2),
- les éléments résistifs variables (4) présentent chacun au moins un premier et un deuxième état,
- dans le premier état, les éléments résistifs variables (4) agissent comme isolants électriques afin d'empêcher le courant électrique de circuler de la première électrode (2) à l'électrode de grille (3) ou vice versa par l'intermédiaire des éléments résistifs variables (4),
- dans le deuxième état, les éléments résistifs variables (4) agissent comme conducteur électrique pour permettre au courant électrique de circuler de la première électrode (2) à l'électrode de grille (3) ou inversement par l'intermédiaire des éléments résistifs variables (4),
- les éléments résistifs variables (4) sont configurés pour effectuer une transition du premier état au deuxième état lorsqu'une température de l'élément résistif variable (4) dépasse une température critique Tc, **caractérisé en ce que**
- un élément résistif variable (4) est situé dans une région du dispositif semi-conducteur (100) au-dessous d'une borne de plage de grille (30) de l'électrode de grille (3) et une pluralité d'éléments résistifs variables (4) est située au-dessous d'un canal de grille (31) de l'électrode de grille (3).

2. Dispositif semi-conducteur (100) selon la revendication 1, dans lequel
- les éléments résistifs variables (4) comprennent un matériau à changement de phase.

3. Dispositif électronique (100) selon l'une quelconque des revendications précédentes, dans lequel
- une conductivité électrique des éléments résistifs variables (4) dans le deuxième état est égale à au moins à 100 fois la conductivité électrique de l'élément résistif variable (4) dans le premier état.

4. Élément semi-conducteur (100) selon l'une quelconque des revendications précédentes, dans lequel
- les éléments résistifs variables (4) sont configurés pour effectuer une transition brusque du premier état au deuxième état lorsque la température de l'élément résistif variable (4) dépasse la température critique Tc.

5. Dispositif électronique (100) selon l'une quelconque des revendications précédentes, dans lequel
- la température critique Tc est supérieure d'au moins 50 °C à une température de fonctionnement normale du dispositif semi-conducteur (100).

6. Dispositif électronique (100) selon l'une quelconque des revendications précédentes, dans lequel
- les éléments résistifs variables (4) comprennent ou sont constitués d'un ou de plusieurs des matériaux suivants : GeTe, Ge₂Sb₂Te₅ dopé Al.

7. Dispositif électronique (100) selon l'une quelconque des revendications précédentes, dans lequel
- le dispositif semi-conducteur est un dispositif semi-conducteur de puissance.

8. Dispositif électronique (100) selon l'une quelconque des revendications précédentes, dans lequel
- le dispositif semi-conducteur (100) comprend un transistor bipolaire à grille isolée et/ou un MOSFET.

9. Procédé de fonctionnement d'un dispositif semi-conducteur (100) selon l'une quelconque des revendications précédentes, comprenant
- le fonctionnement du dispositif à semi-conducteur (100) avec les éléments résistifs variables (4) dans le premier état jusqu'à ce qu'un court-circuit apparaisse dans le dispositif à semi-conducteur (100), ce qui provoque une augmentation de la température dans les éléments résistifs variables (4) au-dessus de la température critique Tc,
- la commutation des éléments résistifs variables (4) du premier état au deuxième état,
- le guidage d'un courant électrique entre le corps semi-conducteur (1) et l'électrode de grille (3) à travers les éléments résistifs variables (4) se trouvant dans le deuxième état.
